# FASCICULE DE BREVET EUROPEEN

(11) **EP 0 356 302 B1**
(45) Date de publication et mention de la délivrance du brevet: **18.11.1993**
(21) Numéro de dépôt: 89402250.8
(22) Date de dépôt: 09.08.1989
(51) Int. Cl.: H04B 10/06, H04J 14/00, H01S 3/00

(54) **Procédé et dispositif de filtrage optique et de photodétection de signaux modulés en intensité**
Verfahren und Vorrichtung zur optischen Filterung und Photodetektion von intensitätsmodulierten Signalen
Method and device for the optical filtration and photodetection of intensity-modulated signals

(30) Priorité: 11.08.1988 FR 8810825
(43) Date de publication de la demande: 28.02.1990
(73) Titulaire: FRANCE TELECOM, 75015 Paris (FR)
(72) Inventeur: Nakajima, Hisao, F-75014 Paris (FR)
(74) Mandataire: Mongrédien, André

(56) Documents cités:
- ELECTRONICS LETTERS, vol. 20, no. 19, 13 septembre 1984, pages 794-795, Staines, Middlesex, GB; A. ALPING et al.: "100 Mbit/s laser diode terminal with optical gain for fibre-optic local area networks"
- APPLIED PHYSICS LETTERS, vol. 50, no. 2, 12 janvier 1987, pages 66-67, American Institute of Physics, New York, US; H. KAWAGUCHI et al.: "Optical frequency-selective amplification in a distributed feedback type semiconductor laser amplifier"
- ELECTRONICS LETTERS, vol. 23, no. 25, 3 décembre 1987, pages 1387-1388, Stevenhage, Herts, GB; G. GROBKOPF et al.: "Optical amplifier configurations with low polarisation sensitivity"
- PATENT ABSTRACTS OF JAPAN, vol. 12, no. 111 (E-598)[2958], 8 avril 1988, page 103 E 598 & JP-A- 62 241 387
- APPLIED PHYSICS LETTERS, vol. 54, no. 11, 13 mars 1989, pages 984-986, American Institute of Physics, New York, US; H. NAKAJIMA: "High-speed and high-gain optical amplifying photodetection in a semiconductor laser amplifier"

## Description

La présente invention concerne un procédé et un dispositif de filtrage optique et de photodétection de signaux optiques modulés en intensité. Elle s'applique notamment à la réalisation de démultiplexeurs en longueur d'onde et de récepteurs optiques pour les réseaux de communication par fibres optiques, destinés à transporter des signaux optiques qui sont modulés en intensité et multiplexés en longueur d'onde et dont les longueurs d'ondes respectives sont très proches les unes des autres. Elle s'applique également, dans le domaine de la spectroscopie infrarouge, à la réalisation de détecteurs infrarouges à fenêtre étroite.

On connaît déjà diverses techniques de démultiplexage en longueur d'onde, en particulier les techniques utilisant les filtres à couche mince, celles qui utilisent les coupleurs directifs et celles qui utilisent les réseaux de diffraction. Cependant les techniques citées sont inadaptées au démultiplexage -à faible coût- de signaux optiques multiplexés en longueur d'onde, dont les longueurs d'ondes respectives sont très proches les unes des autres et sont par exemple distantes de quelques dixièmes de nanomètre seulement.

En effet, les filtres à couche mince et les coupleurs directifs ont de larges bandes passantes optiques de l'ordre de 70 nanomètres par exemple, et de plus ne sont pas accordables en longueur d'onde. Les réseaux de diffraction qui permettraient le démultiplexage envisagé ci-dessus (longueurs d'ondes faiblement espacées) sont théoriquement réalisables mais conduiraient à des démultiplexeurs de dimensions et de coût prohibitifs, étant donné qu'un démultiplexeur du commerce, à réseau de diffraction, a déjà une longueur de 8 cm pour une sélectivité en longueur d'onde de 0,163 nm seulement (c'est-à-dire qu'il ne permet de séparer deux signaux optiques que si les longueurs d'ondes de ceux-ci sont distantes de plus de 0,163 nm).

On peut également songer à utiliser, pour le démultiplexage envisagé, une technique utilisant des filtres périodiques ou même une technique utilisant une détection hétérodyne. Cependant, de telles techniques présentent l'inconvénient de nécessiter -comme toutes les techniques mentionnées précédemment d'ailleurs-l'utilisation de photodétecteurs rapides pour convertir les signaux optiques démultiplexés en signaux électriques.

On connaît enfin, notamment par l'article de H. KAWAGUCHI et al. publié dans Applied Physics Letters 50(2) 12 janvier 1987, p.66 et 67 et par l'article de H. NAKAJIMA publié dans les comptes rendus du congrès ECOC 87, p.121 à 124, acticles auxquels on se référera, une technique qui est appropriée au démultiplexage envisagé ci-dessus et qui utilise à cet effet un amplificateur laser à semi-conducteur de type résonant ("resonant type semiconductor laser amplifier" - en abrégé SLA). Cet amplificateur peut être de type Fabry-Pérot ou de type résonateur distribué ("distributed feedback" -en abrégé DFB). De tels dispositifs sont des filtres optiques accordables en longueur d'onde, qui ont un gain optique important et sont ainsi utilisables à la fois comme amplificateurs et comme filtres optiques.

Cependant, un amplificateur laser à semi-conducteur de type résonant doit également être associé à un photodétecteur rapide pour convertir le signal optique qu'il fournit en un signal électrique.

La présente invention a pour but de remédier à cet inconvénient.

On connaît, par l'article de G.GROBKOPF et al., Electronics Letters, vol. 23, n^{º} 25, 3 décembre 1987, p. 1387 et 1388, l'association en parallèle ou en série de deux amplificateurs optiques permettant de remédier à la sensibilité d'un amplificateur optique à la polarisation de signaux lumineux incidents. On connaît aussi par l'article de A. Alping et al., Electronics Letters, vol. 20, n^{º} 19, 13 septembre 1984, p 794 et 795, un dispositif comportant une diode laser qui reçoit un signal optique modulé et qui peut fonctionner comme un photodétecteur lorsqu'elle est polarisée au-dessous de son courant de seuil.

L'invention a tout d'abord pour objet un procédé de filtrage optique et de photodétection de signaux optiques qui sont polarisés linéairement et modulés en intensité en vue de leur faire transporter des informations, procédé selon lequel on injecte les signaux optiques dans au moins un amplificateur laser à semi-conducteur de type résonateur distribué, au voisinage de la couche active de cet amplificateur, ce dernier étant polarisé au-dessous de son courant de seuil et ayant une longueur d'onde de résonance ajustée de façon à coïncider avec la longueur d'onde d'au moins l'un des signaux optiques de sorte que seul ce signal optique est amplifié par l'amplificateur, procédé caractérisé en ce qu'on détecte la tension électrique existant entre les bornes de l'amplificateur, afin d'obtenir sous forme d'un signal électrique, les informations transportées par le signal optique amplifié, lorsque l'angle entre la direction de polarisation de ce signal optique et la direction de la couche active est faible, l'effet étant optimal lorsque cet angle est nul et cessant lorsque cet angle est égal à 90° degrés.

Par "direction de la couche active", on entend la direction définie par la tranche de cette couche active observée du côté de la face de l'amplificateur, sur laquelle arrivent les signaux optiques.

Ces derniers peuvent être numériques ou analogiques. De plus, l'intensité des signaux optiques peut être faible, par exemple de l'ordre de grandeur de l'intensité des signaux lumineux transportés par les fibres optiques, soit quelques micro-watts, voire moins. Cependant, lorsque les signaux sont analogiques, il convient que leur intensité soit faible pour empêcher la saturation de l'amplificateur.

Avec la présente invention, on obtient donc directement un signal électrique à partir de l'amplificateur utilisé qui sert alors à la fois de filtre passe-bande optique et de photodétecteur rapide, accordable en longueur d'onde.

Ce filtre-photodétecteur est sensible à la polarisation des signaux optiques incidents : les informations transportées par le signal optique amplifié sont d'autant mieux traduites sous forme électrique, que l'angle entre la direction de polarisation de ce signal optique et la direction de la couche active est faible, l'effet étant optimal lorsque cet angle est nul et cessant lorsque cet angle est égal à 90 degrés.

La présente invention peut permettre d'obtenir une sélectivité en longueur d'onde de l'ordre de 0,04 nm, une bande passante électrique supérieure à 400 MHz, voire de quelques GHz et une sensibilité en photodétection ("photodetection responsivity" selon la terminologie anglo-saxonne) de l'ordre de 1000 V/W (20A/W), soit une sensibilité nettement supérieure à celle d'un photodétecteur avalanche au Germanium. Par ailleurs, l'invention peut être mise en oeuvre au moyen d'un dispositif de faible taille, par exemple un dispositif dont la largeur, la hauteur et la longueur valent respectivement 0,4 mm, 0,1 mm et 0,25 mm.

La longueur d'onde de résonance peut être ajustée en réglant la température de l'amplificateur et/ou l'intensité du courant de polarisation de cet amplificateur. La présente invention peut d'ailleurs permettre d'obtenir, pour la longueur d'onde de résonance, une variation de l'ordre de 0,14 nm pour une variation de 1 Kelvin de la température de l'amplificateur et une variation de l'ordre de 0,09 nm pour une variation de 1 mA du courant de polarisation de l'amplificateur.

Ce dernier, qui est un amplificateur de type résonateur distribué, n'a qu'une seule longueur d'onde de résonance et de ce fait il est accordable sur un domaine de longueur d'onde beaucoup plus étendu que l'amplificateur de type Fabry-Pérot ; de plus, il a une plus grande sélectivité en longueur d'onde que ce dernier et il est tout à fait approprié à constituer un filtre optique à fenêtre étroite en longueur d'onde.

La présente invention a également pour objet un dispositif de filtrage et de photodétection de signaux optiques qui sont polarisés linéairement et modulés en intensité en vue de leur faire transporter des informations, ce dispositif comprenant :
- au moins un amplificateur laser à semi-conducteur de type résonateur distribué ayant une longueur d'onde de résonance, les signaux optiques étant destinés à être injectés dans cet amplificateur, au voisinage de la couche active de celui-ci,
- des moyens de polarisation de l'amplificateur au-dessous de son courant de seuil,
- des moyens pour ajuster la longueur d'onde de résonance de l'amplificateur de façon qu'elle coïncide avec la longueur d'onde d'au moins l'un des signaux optiques de sorte que seul ce signal optique est amplifié par l'amplificateur,
dispositif caractérisé en ce qu'il comprend en outre des moyens de détection de la tension électrique existant entre les bornes de l'amplificateur, afin d'obtenir sous forme d'un signal électrique, les informations transportées par le signal optique amplifié, lorsque l'angle entre la direction de polarisation de ce signal optique et la direction de la couche active est faible, l'effet étant optimal lorsque cet angle est nul et cessant lorsque cet angle est égal à 90° degrés.

Selon un mode de réalisation particulier du dispositif objet de l'invention, ledit amplificateur est unique et destiné à recevoir une pluralité de signaux optiques modulés en intensité et polarisés linéairement, dont les longueurs d'ondes respectives sont différentes les unes des autres et dont les directions de polarisation sont confondues, en vue de faire coïncider la longueur d'onde de résonance de l'amplificateur avec la longueur d'onde de l'un des signaux.

Dans ce cas, de préférence, les directions de polarisation respectives des signaux optiques sont parallèles à la direction de la couche active de l'amplificateur.

Selon un autre mode de réalisation particulier, le dispositif objet de l'invention comprend N amplificateurs lasers à semi-conducteur de type résonateur distribué, destinés à recevoir chacun N signaux optiques modulés en intensité et polarisés linéairement, dont les longueurs d'ondes respectives sont différentes les unes des autres, N étant un nombre entier au moins égal à 2, en vue de faire coïncider les longueurs d'ondes de résonance des N amplificateurs respectivement avec les N longueurs d'ondes des signaux optiques.

Dans ce cas, les couches actives respectives des N amplificateurs peuvent être parallèles, les directions de polarisation respectives des N signaux optiques étant alors parallèles les unes aux autres, les directions des couches actives respectives des N amplificateurs étant parallèles à ces directions de polarisation.

Selon un autre mode de réalisation particulier, le dispositif objet de l'invention comprend deux amplificateurs lasers à semi-conducteur de type résonateur distribué, dont les couches actives sont perpendiculaires et qui sont destinés à recevoir chacun deux signaux optiques de même longueur d'onde, modulés en intensité et polarisés linéairement, les directions de polarisation respectives de ces signaux étant perpendiculaires et l'un d'entre eux étant parallèle à la couche active de l'un des amplificateurs, afin de détecter les deux signaux optiques respectivement par les deux amplificateurs lorsque la longueur d'onde de résonance de chacun de ces derniers coïncide avec ladite même longueur d'onde.

Les deux signaux optiques peuvent être indépendants, ou bien ces deux signaux optiques peuvent être numériques et complémentaires l'un de l'autre, le dispositif comprenant alors en outre des moyens soustracteurs prévus pour fournir en sortie un signal électrique égal à la différence entre les signaux électriques respectivement fournis par les amplificateurs.

Enfin, selon un autre mode de réalisation particulier, le dispositif objet de l'invention comprend :
- deux amplificateurs lasers à semiconducteur de type résonateur distribué, dont les couches actives sont perpendiculaires et qui sont destinés à recevoir chacun le même signal optique, ce signal optique ayant une longueur d'onde donnée et étant modulé en intensité et polarisé linéairement, la direction de polarisation de ce signal étant parallèle à la direction de la couche active de l'un des amplificateurs, et
- des moyens additionneurs prévus pour additionner les signaux électriques fournis respectivement par les deux amplificateurs lorsque la longueur d'onde de résonance de chacun de ces derniers coïncide avec la longueur d'onde donnée, afin d'obtenir sous forme d'un signal électrique, à la sortie des moyens additionneurs, les informations transportées par ledit même signal optique.

La présente invention sera mieux comprise à la lecture de la description qui suit, d'exemples de réalisation donnés à titre purement indicatif et nullement limitatif, en référence aux dessins annexés sur lesquels :
- la figure 1 illustre schématiquement le principe de l'invention, et la figure 1A illustre schématiquement un procédé de filtrage et de photodétection au moyen d'un amplificateur laser de type Fabry-Pérot,
- la figure 2 est une vue schématique d'un dispositif conforme à l'invention et formant un récepteur optique,
- les figures 3A et 3B sont des graphiques montrant les niveaux de puissance détectés avec ce récepteur, respectivement pour deux signaux optiques de longueurs d'ondes différentes,
- la figure 4 est une vue schématique d'un dispositif conforme à l'invention et formant un démultiplexeur à N canaux,
- la figure 5 est une vue schématique d'un dispositif conforme à l'invention et formant un récepteur de signaux optiques dont les directions de polarisation respectives sont perpendiculaires, et
- les figures 6 et 7 sont des vues schématiques de dispositifs conformes à l'invention et formant des récepteurs de signaux optiques.

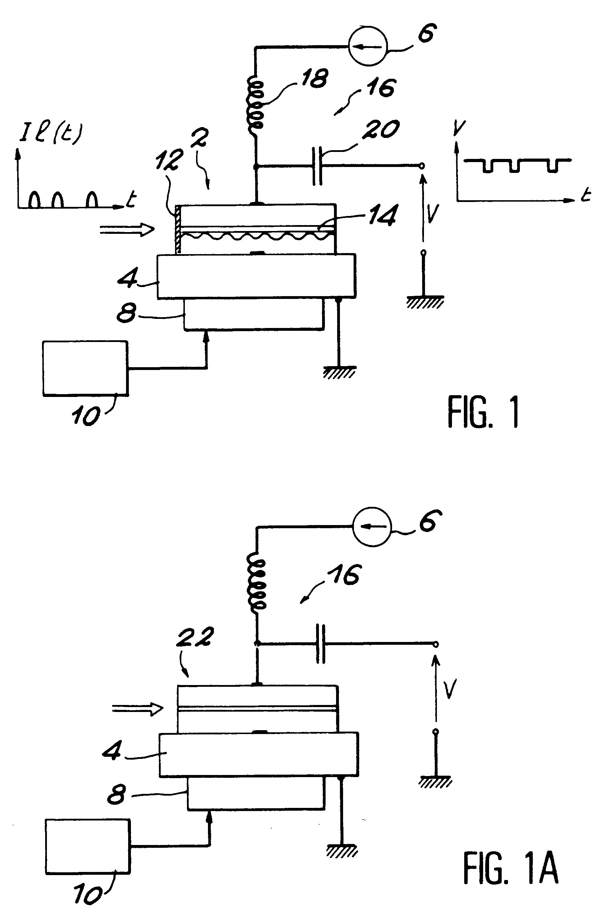

La figure 1 illustre schématiquement le principe de la présente invention. On utilise dans cette dernière un amplificateur laser à semi-conducteur de type résonateur distribué ("Distributed Feedback"), encore appelé "diode laser à résonateur distribué''. Une borne de cette diode laser 2 est mise à la masse par l'intermédiaire de l'embase 4, par exemple en cuivre, sur laquelle la diode se trouve. Cette diode est polarisée jusqu'au-dessous de son courant de seuil au moyen d'une source 6 de courant électrique Ib constant, reliée à l'autre borne de la diode. Ainsi, la diode laser 2, qui possède une seule longueur d'onde de résonance lo, fonctionne comme un amplificateur résonnant. La longueur d'onde lo peut être ajustée en modifiant le courant de polarisation Ib de l'amplificateur (en réglant la source 6) ou en modifiant la température de cet amplificateur au moyen d'un élément thermoélectrique, par exemple un élément Peltier 8, qui est en contact thermique avec l'embase 4. Par ailleurs, on peut maintenir cette température sensiblement constante grâce à un circuit d'asservissement 10 qui commande l'élément 8 et qui comporte un capteur de température non représenté, par exemple une thermistance, en contact thermique avec l'embase 4.

Le réglage de lo peut aussi être fait en agissant à la fois sur la température de la diode laser et sur le courant de polarisation de celle-ci.

On envoie sur une face de la diode laser 2, ou face d'entrée, de préférence munie d'une couche anti-reflet 12, des signaux optiques de longueur d'onde l dont l'intensité Il(t) est modulée (c'est-à-dire varie en fonction du temps d'une façon déterminée). Plus précisément, ces signaux optiques sont envoyés perpendiculairement à la face d'entrée et de façon à tomber au voisinage de la couche active 14 de la diode laser 2. En outre, ces signaux optiques sont sous la forme d'une lumière qui est polarisée linéairement et dont la direction de polarisation est parallèle à la direction de la couche active 14.

En choisissant la diode laser 2 de façon que le domaine dans lequel on peut faire varier lo contienne la longueur l des signaux, on peut donc régler lo de façon qu'elle coïncide avec l.

On constate alors que la tension V entre les bornes de la diode laser diminue, lorsque la lumière est présente à l'entrée de cette diode laser, par rapport à la valeur de V lorsque la lumière est absente. Cette diminution est proportionnelle à l'intensité de la lumière, pour de faibles intensités lumineuses. L'effet observé a lieu uniquement lorsque l est sensiblement égal à lo.

En détectant cette variation de tension au cours du temps, on peut donc acquérir, sous forme de signaux électriques, les informations qui sont envoyées sur la diode laser 2 sous la forme de signaux optiques modulés en intensité.

On constate par ailleurs que la diminution de la tension est d'autant plus importante que le courant de polarisation Ib est proche du courant de seuil de la diode laser.

On constate également que l'effet observé diminue lorsque la direction de polarisation de la lumière s'écarte du plan de la couche active, d'où un effet qui est sensible à la polarisation des signaux optiques.

L'alimentation en courant constant et la détection de la tension V peuvent être effectuées par l'intermédiaire d'un T de polarisation 16 comprenant, de façon classique, une inductance 18 et une capacité 20 qui ont une borne commune reliée à ladite autre borne de la diode laser 2, l'autre borne de l'inductance 18 étant reliée à la source 6 et l'autre borne de la capacité 20 permettant le recueil du signal de tension V. Ce signal est ensuite exploité de manière classique.

La figure 1A illustre schématiquement un procédé de filtrage et de photodétection qui utilise un amplificateur laser à semi-conducteur de type résonnant, de type Fabry-Perot 22 (qui ne comporte pas de couche anti-reflet) au lieu de la diode laser 2. On choisit alors cet amplificateur de façon que le domaine dans lequel on peut faire varier l'une de ses longueurs d'ondes de résonance lr contienne l et l'on règle lr de façon qu'elle coïncide avec l.

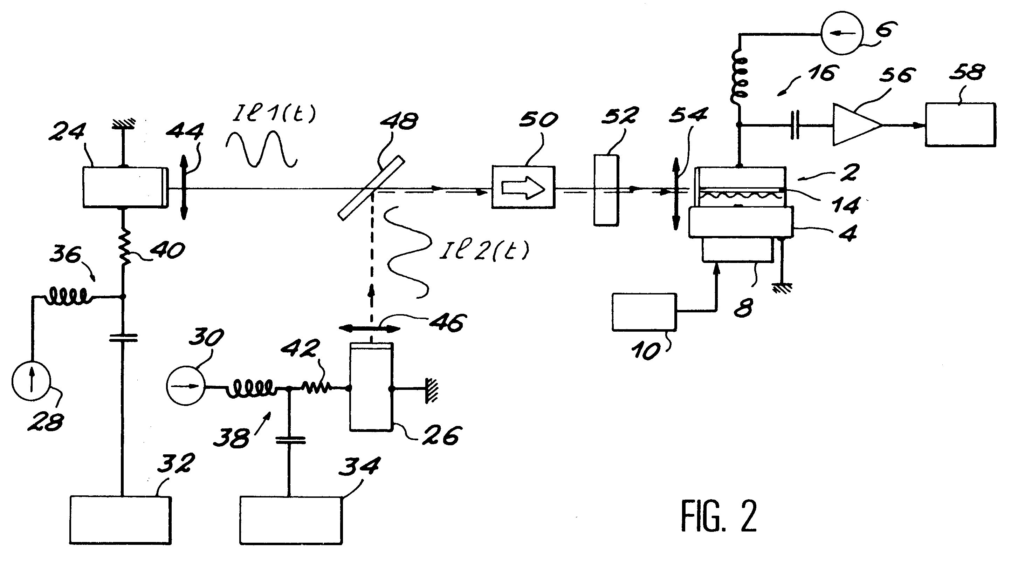

La figure 2 illustre schématiquement une application de l'invention à la réalisation d'un récepteur optique. Ce récepteur utilise la possibilité d'accorder la longueur d'onde du filtre optique que constitue une diode laser à résonateur distribué convenablement polarisée, ainsi que la large bande passante électrique de cette diode. Ce récepteur permet ainsi de sélectionner un canal de transmission parmi une pluralité de canaux de haut débit. Chaque canal est affecté d'une longueur d'onde optique qui lui est propre et les longueurs d'onde des canaux peuvent être réparties dans un domaine de longueurs d'ondes de 3 nanomètres environ, avec un écart entre deux longueurs d'ondes adjacentes qui peut être de l'ordre de quelques dixièmes de nanomètre, ce qui permet d'avoir au moins 10 canaux, voire plus. L'exemple de la figure 2 est limité à 2 canaux.

Le récepteur schématiquement représenté sur la figure 2 permet donc de sélectionner un canal parmi deux canaux dont les longueurs d'ondes respectives sont notées l1 et l2 et sont très proches l'une de l'autre.

Des signaux optiques de longueur d'onde l1 (respectivement l2) polarisés linéairement et dont l'intensité notée Il1(t) (respectivement Il2(t)) est modulée, sont émis par une diode laser à résonateur distribué 24 (respectivement 26) dont le courant de polarisation est faiblement modulé. On voit sur la figure 2 un générateur de courant constant 28 (respectivement 30) et un oscillateur 32 (respectivement 34) qui permettent cette modulation du courant de polarisation de la diode laser 24 (respectivement 26) par l'intermédiaire d'un T de polarisation 36 (respectivement 38), ce T de polarisation étant connecté à la diode 24 (respectivement 26) par l'intermédiaire d'une résistance 40 (respectivement 42) permettant d'adapter l'impédance.

La lumière émise par la diode 24 (respectivement 26) est transformée en un faisceau parallèle au moyen d'une optique appropriée 44 (respectivement 46). Les deux faisceaux obtenus sont envoyés sur une lame semi-transparente 48 en sortie de laquelle on obtient un faisceau unique dans lequel sont mélangés les deux signaux optiques de longueurs d'ondes l1 et l2. Les diodes 24 et 26 sont disposées de façon que, dans ce faisceau unique, les directions de polarisation des signaux optiques soient confondues. Ce faisceau unique est envoyé sur la face d'entrée de la diode laser à résonateur distribué 2 successivement par l'intermédiaire d'un isolateur optique de Faraday 50, qui est prévu pour éviter les "rétro-couplages" de la diode 2 vers les diodes 24 et 26, d'une lame demi-onde 52 et d'un objectif de microscope 54. La lame demi-onde 52 est prévue pour ramener la direction de polarisation commune aux deux signaux à l'état qu'elle avait avant de traverser l'isolateur 50. Le fait que l1 et l2 sont très proches l'une de l'autre permet effectivement d'utiliser une seule lame demi-onde. La diode laser 2 est disposée de façon que sa couche active soit parallèle à la direction de polarisation commune aux signaux optiques et que le faisceau unique arrive au voisinage de la couche active de cette diode. En outre, cette dernière est polarisée au-dessous de son courant de seuil.

A titre purement indicatif et nullement limitatif, la diode laser 2 a les caractéristiques suivantes : pas du réseau = 0,46 micromètre, ordre du réseau = 2, coefficient de couplage = environ 50 cm⁻¹, courant de seuil à 20°C = 42,3 mA.

La température de la diode laser 2 est stabilisée par exemple à 20°C environ au moyen de l'élément Peltier 8 associé au circuit d'asservissement 10. On peut également stabiliser en température, d'une manière analogue, les diodes laser 24 et 26. Le signal correspondant à la tension V entre les bornes de la diode laser 2 est récupéré par l'intermédiaire du T de polarisation 16 et envoyé, après avoir été amplifié par un amplificateur 56, à un analyseur de spectre haute fréquence 58. L'amplificateur 56 est un amplificateur à large bande (0,01 GHz - 2 GHz), de gain 32 dB par exemple.

Les diodes laser 24 et 26 sont par exemple réglées de façon que l2 - l1 soit égal à 0,13 nanomètre (l1 = 1505 nm et l2 = 1505,13 nm) et la fréquence de modulation relative à l1 (respectivement l2) est par exemple égale à 280 MHz (respectivement 347 MHz).

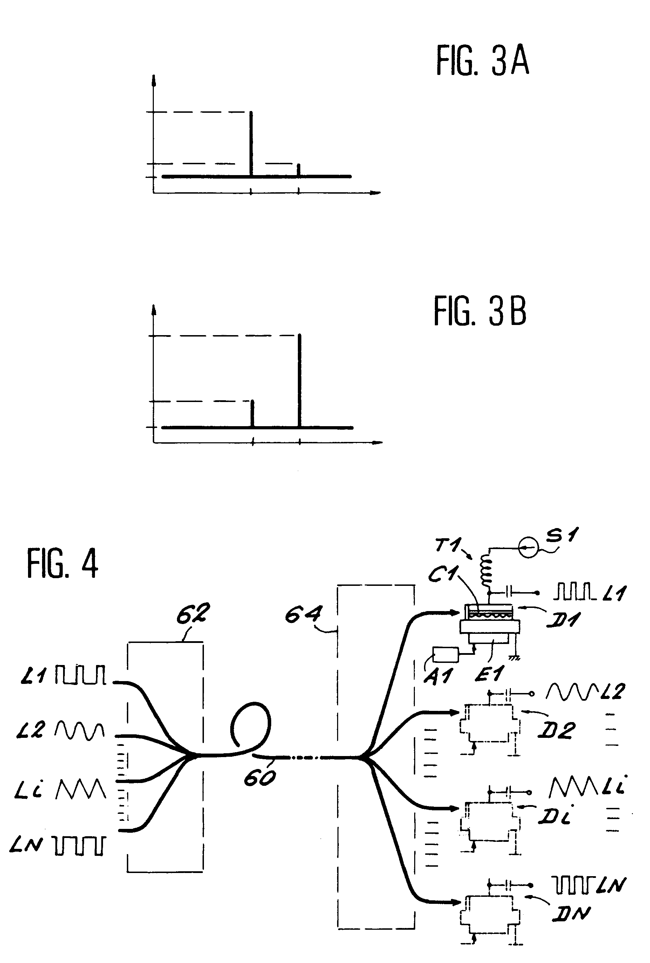

Les signaux optiques mélangés tombant sur la diode laser 2 au voisinage de la couche active de celle-ci, on règle le courant de polarisation de cette diode laser 2 à 38 mA pour accorder sa longueur d'onde de résonance lo à celle de la diode laser 24 (l1). On observe alors clairement sur l'analyseur de spectre les signaux de 280 MHz issus de la diode laser 24. Une diaphonie de -11 dB du canal 2 (relatif à la diode laser 26) au canal 1 (correspondant à la diode laser 24) est observée (voir la figure 3A).

En réglant ensuite le courant de polarisation de la diode laser 2 à 39,4 mA, la longueur d'onde de résonance de cette diode laser 2 est accordée sur celle de la diode laser 26 (l2). On observe alors sur l'analyseur 58 les signaux de 347 MHz correspondant à la diode laser 26. Une diaphonie de -15 dB du canal 1 au canal 2 est alors observée (voir figure 3B).

La figure 4 illustre schématiquement une application de l'invention à la réalisation d'un démultiplexeur en longueur d'onde à N canaux correspondant respectivement à des signaux optiques de longueurs d'ondes L1, L2, ... Li,... LN différentes. Ces signaux optiques, qui sont modulés en intensité, sont polarisés linéairement et ont des directions de polarisation parallèles, sont injectés dans une fibre optique monomode 60, par l'intermédiaire d'un coupleur optique 62 "N vers 1". Le démultiplexeur comprend N diodes lasers à résonateur distribué D1, D2, ... Di, ... DN. Les signaux optiques multiplexés en longueur d'onde qui sont transportés par la fibre 60 sont distribués, par l'intermédiaire d'un coupleur 64 "1 vers N", à chacune des N diodes lasers D1, ... DN et injectés au voisinage des couches actives respectives (telles que C1) de ces diodes. Ces couches actives sont parallèles et les directions de polarisation des signaux optiques sont parallèles à ces couches. On peut, si cela est nécessaire, interposer entre chaque branche du coupleur 64 et la diode laser correspondante un moyen permettant de ramener la polarisation des signaux optiques à son état initial, c'est-à-dire l'état qu'elle avait avant l'entrée dans le coupleur 62. Toutes les diodes lasers sont polarisées au-dessous de leur courant de seuil de sorte qu'elles fonctionnent en amplificateurs et les N longueurs d'ondes de résonance des N diodes laser sont respectivement accordées sur les N longueurs d'ondes des signaux optiques en agissant de façon appropriée sur le courant de polarisation et/ou la température de chacune des diodes laser. Chaque diode laser, telle que D1, est reliée, par l'intermédiaire d'un T de polarisation, tel que T1, à une source de courant constant, telle que S1. Pour régler la polarisation de chaque diode laser telle que D1, on règle donc la source de courant constant correspondante et/ou la température de cette diode laser qui est munie à cet effet d'un élément Peltier E1 associé à un circuit d'asservissement A1.

On extrait alors, respectivement par l'intermédiaire des T de polarisation, N signaux électriques correspondant respectivement aux N signaux optiques.

On obtient un démultiplexeur qui présente une bonne sélectivité en longueur d'onde et une bonne sensibilité en photodétection et dont les amplificateurs-diodes-lasers qu'il comporte ont une large bande passante électrique.

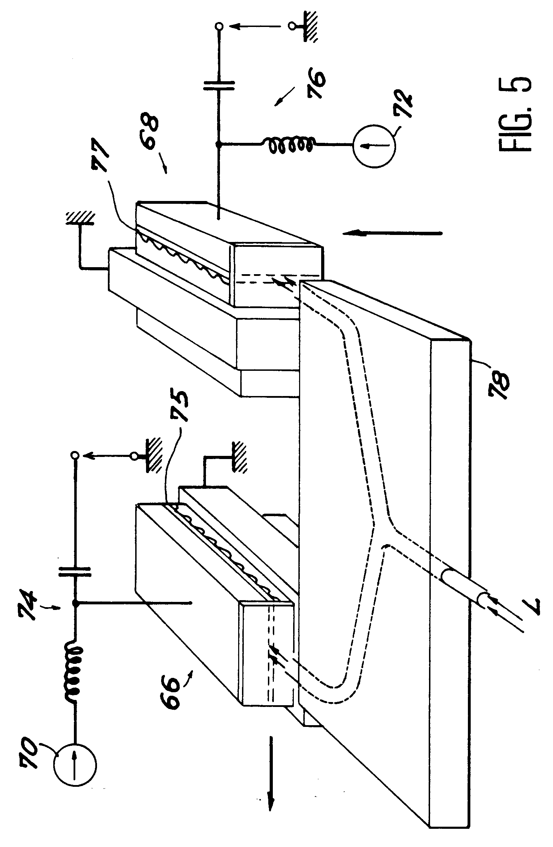

La figure 5 illustre schématiquement une application de la présente invention à la réalisation d'un récepteur de signaux optiques. Ce récepteur comprend deux diodes laser à résonateur distribué 66 et 68. La diode 66 (respectivement 68) est polarisée au-dessous de son courant de seuil au moyen d'une source de courant constant 70 (respectivement 72), par l'intermédiaire d'un T de polarisation 74 (respectivement 76). Le récepteur utilise la bonne sensibilité en polarisation optique et la large bande passante électrique des diodes laser fonctionnant en amplificateurs qu'il comporte. Ces diodes lasers 66 et 68 sont disposées de façon que leurs couches actives respectives 75 et 77 soient perpendiculaires l'une à l'autre.

En outre, les longueurs d'ondes de résonance respectives de ces diodes lasers sont réglées pour être égales à une même valeur L, longueur d'onde commune à deux signaux optiques qui sont tous deux polarisés linéairement et dont les directions de polarisation respectives sont perpendiculaires l'une à l'autre. Ces deux signaux optiques sont mélangés au sein d'un même faisceau lumineux et envoyés, par l'intermédiaire d'un coupleur 78 en Y, sur la face d'entrée (de préférence munie d'une couche anti-reflet), et au voisinage de la couche active, de chacune des diodes lasers 66 et 68. Le coupleur 78 a ainsi deux branches qui sont respectivement en regard des diodes lasers 66 et 68. Chaque diode est orientée par rapport à la branche correspondante du coupleur de façon que sa couche active soit parallèle à l'une des directions de polarisation respectives des signaux de sorte que les deux diodes 66 et 68 sélectionnent respectivement les deux signaux.

Pour illustrer ceci, on suppose que l'un des signaux a une polarisation horizontale et que l'autre signal a une polarisation verticale et la couche active de la diode 66 est horizontale, cette diode 66 sélectionnant ainsi le signal à polarisation horizontale, tandis que la couche active de la diode 68 est verticale, cette diode 68 sélectionnant ainsi le signal à polarisation verticale.

On extrait alors, par l'intermédiaire du T de polarisation 74 (respectivement 76) le signal électrique correspondant au signal optique sélectionné par la diode laser 66 (respectivement 68).

On comprend donc que le récepteur représenté sur la figure 5 permet de doubler le nombre de canaux de transmission. De plus, il ne nécessite aucun photodétecteur (autre que les diodes 66 et 68).

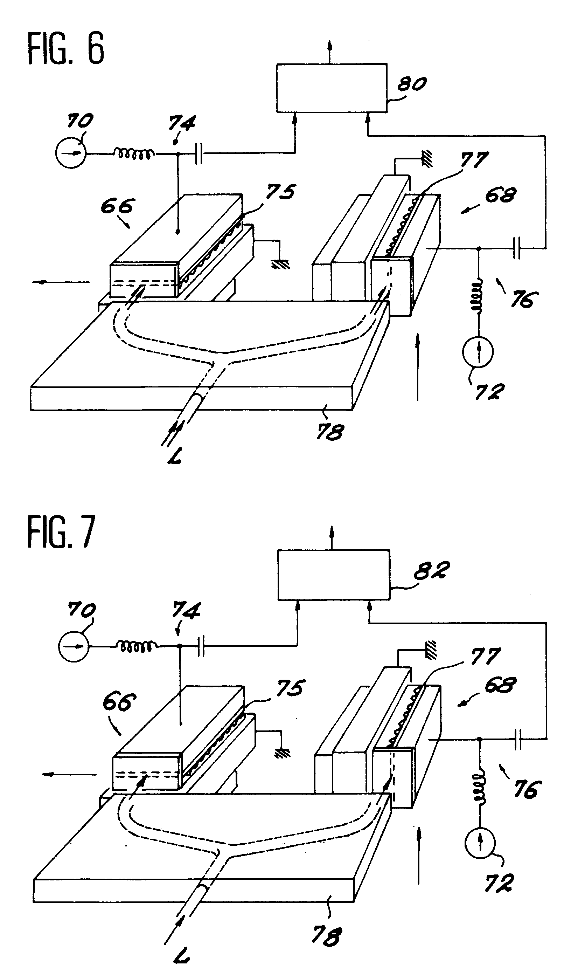

Sur la figure 6, on a représenté schématiquement un autre récepteur qui diffère de celui qui est représenté sur la figure 5 par le fait qu'il comprend en outre des moyens soustracteurs 80 dont les deux entrées reçoivent respectivement les deux signaux électriques fournis par les diodes 66 et 68, par l'intermédiaire des T de polarisation 74 et 76, et qui fournissent en sortie un signal électrique égal à la différence entre ces deux signaux électriques. De plus, les signaux optiques de même longueur d'onde L ne sont plus ici indépendants comme ils l'étaient dans le cas de la figure 5 : ce sont des signaux numériques complémentaires l'un de l'autre c'est-à-dire que lorsque l'un de ces signaux est à l'état logique 1, l'autre est à l'état logique 0 et réciproquement, ces signaux transportant ainsi la même information.

On voit donc que l'on obtient cette information à la sortie des moyens 80 avec un bon rapport signal sur bruit, même lorsqu'une rotation de direction de polarisation se produit avant l'arrivée des signaux optiques aux diodes lasers 66 et 68.

Sur la figure 7, on a représenté schématiquement un autre récepteur qui diffère de celui qui est représenté sur la figure 5 par le fait qu'il comprend en outre des moyens additionneurs 82 dont les deux entrées reçoivent respectivement les deux signaux électriques fournis par les diodes 66 et 68, par l'intermédiaire des T de polarisation 74 et 76, et qui fournissent en sortie un signal électrique égal à la somme de ces deux signaux électriques. De plus, un seul signal optique de longueur d'onde L (au lieu de deux signaux) est envoyé à l'entrée du coupleur 78. Les couches actives respectives des diodes 66 et 68 sont encore perpendiculaires l'une à l'autre et le signal optique incident a une polarisation rectiligne et une direction de polarisation parallèle à la direction de la couche active de l'une des diodes 66 et 68.

On voit donc que l'on obtient, à la sortie des moyens 82, l'information transportée par le signal optique, et ceci, avec un bon rapport signal sur bruit, même lorsque ce signal optique subit une rotation de sa direction de polarisation avant son arrivée aux diodes lasers 66 et 68.

## Revendications

1. Procédé de filtrage optique et de photodétection de signaux optiques qui sont polarisés linéairement et modulés en intensité en vue de leur faire transporter des informations, procédé selon lequel on injecte les signaux optiques dans au moins un amplificateur laser à semi-conducteur de type résonateur distribué (2; D1 ... DN; 66, 68), au voisinage de la couche active (14; 75, 77) de cet amplificateur, ce dernier étant polarisé au-dessous de son courant de seuil et ayant une longueur d'onde de résonance ajustée de façon à coïncider avec la longueur d'onde d'au moins l'un des signaux optiques de sorte que seul ce signal optique est amplifié par l'amplificateur, procédé caractérisé en ce qu'on détecte la tension électrique existant entre les bornes de l'amplificateur, afin d'obtenir, sous forme d'un signal électrique, les informations transportées par le signal optique amplifié, lorsque l'angle entre la direction de polarisation de ce signal optique et la direction de la couche active est faible, l'effet étant optimal lorsque cet angle est nul et cessant lorsque cet angle est égal à 90° degrés.

2. Procédé selon la revendication 1, caractérisé en ce que la longueur d'onde de résonance est ajustée en réglant la température de l'amplificateur et/ou l'intensité du courant de polarisation de cet amplificateur.

3. Dispositif de filtrage optique et de photodétection de signaux optiques qui sont polarisés linéairement et modulés en intensité en vue de leur taire transporter des informations, ce dispositif comprenant :
- au moins un amplificateur laser à semi-conducteur de type résonateur distribué (2; D1 ... DN; 66, 68) ayant une longueur d'onde de résonance, les signaux optiques étant destinés à être injectés dans cet amplificateur, au voisinage de la couche active (14; 75, 77) de celui-ci,
- des moyens (6; S1; 70, 72) de polarisation de l'amplificateur au-dessous de son courant de seuil,
- des moyens (8, 10; E1, A1) pour ajuster la longueur d'onde de résonance de l'amplificateur de façon qu'elle coïncide avec la longueur d'onde d'au moins l'un des signaux optiques de sorte que seul ce signal optique est amplifié par l'amplificateur, dispositif caractérisé en ce qu'il comprend en outre des moyens (16; T1; 74, 76) de détection de la tension électrique existant entre les bornes de l'amplificateur, afin d'obtenir, sous forme d'un signal électrique, les informations transportées par le signal optique amplifié, lorsque l'angle entre la direction de polarisation de ce signal optique et la direction de la couche active est faible, l'effet étant optimal lorsque cet angle est nul et cessant lorsque cet angle est égal à 90° degrés.

4. Dispositif selon la revendication 3, caractérisé en ce que ledit amplificateur laser à semi-conducteur de type résonateur distribué (2) est unique et destiné à recevoir une pluralité de signaux optiques modulés en intensité et polarisés linéairement, dont les longueurs d'ondes respectives sont différentes les unes des autres et dont les directions de polarisation sont confondues, en vue de taire coïncider la longueur d'onde de résonance de l'amplificateur avec la longueur d'onde de l'un des signaux.

5. Dispositif selon la revendication 4, caractérisé en ce que les directions de polarisation respectives des signaux optiques sont parallèles à la direction de la couche active (14) de l'amplificateur (2).

6. Dispositif selon la revendication 3, caractérisé en ce qu'il comprend N amplificateurs lasers à semi-conducteur de type résonateur distribué (D1 ... DN), destinés à recevoir chacun N signaux optiques modulés en intensité et polarisés linéairement, dont les longueurs d'ondes respectives sont différentes les unes des autres, N étant un nombre entier au moins égal à 2, en vue de faire coïncider les longueurs d'ondes de résonance des N amplificateurs respectivement avec les N longueurs d'ondes des signaux optiques.

7. Dispositif selon la revendication 6, caractérisé en ce que les couches actives respectives (C1) des N amplificateurs sont parallèles et en ce que les directions de polarisation respectives des N signaux optiques sont parallèles les unes aux autres, les directions des couches actives respectives des N amplificateurs étant parallèles à ces directions de polarisation.

8. Dispositif selon la revendication 3, caractérisé en ce qu'il comprend deux amplificateurs lasers à semi-conducteur de type résonateur distribué (66, 68), dont les couches actives (75, 77) sont perpendiculaires et qui sont destinés à recevoir chacun deux signaux optiques de même longueur d'onde, modulés en intensité et polarisés linéairement, les directions de polarisation respectives de ces signaux étant perpendiculaires et l'un d'entre eux étant parallèle à la couche active de l'un des amplificateurs, afin de détecter les deux signaux optiques respectivement par les deux amplificateurs lorsque la longueur d'onde de résonance de chacun de ces derniers coïncide avec ladite même longueur d'onde.

9. Dispositif selon la revendication 8, caractérisé en ce que les deux signaux optiques sont indépendants.

10. Dispositif selon la revendication 8, caractérisé en ce que les deux signaux optiques sont numériques et complémentaires l'un de l'autre et en ce que le dispositif comprend en outre des moyens soustracteurs (80) prévus pour fournir en sortie un signal électrique égal à la différence entre les signaux électriques respectivement fournis par les amplificateurs.

11. Dispositif selon la revendication 3, caractérisé en ce qu'il comprend :
- deux amplificateurs lasers à semi-conducteur de type résonateur distribué (66, 68), dont les couches actives (75, 77) sont perpendiculaires et qui sont destinés à recevoir chacun le même signal optique, ce signal optique ayant une longueur d'onde donnée et étant modulé en intensité et polarisé linéairement, la direction de polarisation de ce signal étant parallèle à la direction de la couche active de l'un des amplificateurs, et
- des moyens additionneurs (82) prévus pour additionner les signaux électriques fournis respectivement par les deux amplificateurs lorsque la longueur d'onde de résonance de chacun de ces derniers coïncide avec la longueur d'onde donnée, afin d'obtenir sous forme d'un signal électrique, à la sortie des moyens additionneurs, les informations transportées par ledit même signal optique.

## Claims

1. Method for the optical filtering and photodetection of optical signals which are linearly polarized and intensity-modulated in order to have them carry information, a method whereby optical signals are injected into at least one distributed feedback semiconductor amplifier (2, D1 ... DN, 66, 68) close to the active layer (14, 75, 77) of this amplifier, the latter being polarized below its threshold current and having at least one resonance wavelength adjusted so as to coincide with the wavelength of one of the optical signals so that only this optical signal is amplified by the amplifier and characterized in that the electric voltage existing between the terminals of the amplifier is detected so as to obtain, in the form of an electric signal, the information borne by the amplified optical signal when the angle between the polarization direction of this optical signal and the direction of the active layer is small, the effect being of an optimum nature when said angle is zero and stopping when the angle is equal to 90°.

2. Method according to claim 1, characterized in that the resonance wavelength is adjusted by adjusting the temperature of the amplifier and/or the intensity of the polarization current of this amplifier.

3. Device for the optical filtering and photodetection of optical signals which are linearly polarized and intensity-modulated in order to have them carry information, said device comprising:
- at least one distributed feedback type semiconductor, laser amplifier (2, D1 ... DN, 66, 68) having at least one resonance wavelength, the optical signals being intended to be injected into this amplifier close to the active layer (14, 75, 77) of the latter,
- means (6, 51, 70, 72) to polarize the amplifier below its threshold current,
- means (8, 10, E1, A1) to adjust the resonance wavelength of the amplifier so that it coincides with the wavelength of at least one of the optical signals so that only this optical signal is amplified by the amplifier, characterized in that it also comprises
- means (16, T1, 74, 76) to detect the electric voltage listing between the terminals of the amplifier so as to obtain, in the form of an electric signal, the information borne by the amplified optical signal when the angle between the polarization direction of this optical signal and the direction of the active layer is small, wherein the effect is of an optimum nature when said angle is zero and stops when the angle is equal to 90°.

4. Device according to claim 3, characterized in that said distributed feedback type semiconductor laser amplifier (2) is intended to receive a plurality of intensity-modulated and linearly polarized optical signals whose respective wavelengths are all different and whose polarization directions are merged so as to have the resonance wavelength of the amplifier coincide with the wavelength of one of the signals.

5. Device according to claim 4, characterized in that the respective polarization directions of the optical signals are parallel to the direction of the active layer (14) of the amplifier (2).

6. Device according to claim 3, characterized in that it comprises N distributed feedback type semiconductor laser amplifiers (D1 ... DN), each intended to receive N linearly polarized and intensity-modulated optical signals whose respective wavelengths are different from each other, N being a whole number at least equal to 2 so as to have the resonance wavelengths of N amplifiers respectively coincide with the N wavelengths of the optical signals.

7. Device according to claim 6, characterized in that the respective active layers (C1) of the N amplifiers are parallel and the respective polarization directions of the N optical signals are parallel to each other, the directions of the respective active layers of the N amplifiers being parallel to these polarization directions.

8. Device according to claim 3, characterized in that it comprises two distributed feedback type semiconductor laser amplifies (66, 68) whose active layers (75, 77) are perpendicular and which are intended to each receive two linearly polarized and intensity-modulated optical signals of the same wavelength, the respective polarization directions of these signals being perpendicular with one of them being parallel to the active layer of one of the amplifiers so as to respectively detect the two optical signals by the two amplifiers when the resonance wavelength of each of the latter coincide with said same wavelength.

9. Device according to claim 8, characterized in that the two optical signals are independent.

10. Device according to claim 8, characterized in that the two optical signals are digital and complimentary to each other, the device further comprising subtracting means (80) provided so as to output supply an electric signal equal to the difference between the electric signals respectively supplied by the amplifiers.

11. Device according to claim 3, characterized in that it comprises:
- two distributed feedback type semiconductor laser amplifiers (66, 68) whose active layers (75, 77) are perpendicular and which are intended to each receive the same optical signal, this optical signal having a given wavelength and being linearly polarized and intensity-modulated, the polarization direction of this signal being parallel to the direction of the active layer of one of the amplifiers, and
- adding means (82) provided to add up the electric signals respectively supplied by the two amplifiers when the resonance wavelength of each of the latter coincides with the given wavelength so as to obtain, in the form of an electric signal, the information borne by said optical signal at the output of the adding means.

## Patentansprüche

1. Verfahren zur optischen Filterung und Photodetektion von optischen Signalen, welche linear polarisiert und intensitätsmoduliert sind hinsichtlich dessen, sie Informationen transportieren zu lassen, ein Verfahren, gemäß welchem man die optischen Signale in mindestens einen Verstärker mit Halbleiterlaser des Typs eines verteilten Resonators (2; D1 ... DN; 66, 68) einführt, in der Nähe der aktiven Schicht (14; 75, 77) dieses Verstärkers, wobei dieser letztere unterhalb seines Schwellenstroms polarisiert ist und eine Resonanzwellenlänge hat, die so eingestellt ist, daß sie mit der Wellenlänge von mindestens einem der optischen Signale zusammenfällt, so daß nur dieses optische Signal durch den Verstärker verstärkt wird, ein Verfahren,
dadurch **gekennzeichnet,**
daß man die zwischen den Anschlußklemmen des Verstärkers auftretende elektrische Spannung detektiert, um in Form eines elektrischen Signals die durch das verstärkte optische Signal transportierten Informationen erhält, wenn der Winkel zwischen der Polarisationsrichtung dieses optischen Signals und der Richtung der aktiven Schicht klein ist, wobei dieser Effekt optimal ist, wenn dieser Winkel Null ist und aufhört, wenn der Winkel gleich 90° ist.

2. Verfahren gemäß Anspruch 1, dadurch gekennzeichnet, daß die Resonanzwellenlänge eingestellt wird, indem man die Temperatur des Verstärkers und/oder die Intensität des Polarisationsstroms dieses Verstärkers reguliert.

3. Vorrichtung zur optischen Filterung und zur Photodetektion von optischen Signalen, welche linear polarisiert und intensitätsmoduliert sind, hinsichtlich dessen, sie Informationen transportieren zu lassen, diese Vorrichtung umfaßt:
- mindestens einen Verstärker mit Halbleiterlaser vom Typ eines verteilten Resonators (2; D1, ... DN; 66, 68), welcher eine Resonanzwellenlänge hat, wobei die optischen Signale bestimmt werden, indem sie in diesen Verstärker, in der Nähe von dessen aktiver Schicht (14; 75, 77) eingeführt werden,
- Polarisationsmittel (6; S1; 70, 72) des Verstärkers unterhalb seines Schwellenstroms,
- Mittel (8, 10; E1, A1) um die Resonanzwellenlänge des Verstärkers einzustellen, so daß sie mit der Wellenlänge von mindestens einem der optischen Signale zusammenfällt, so daß nur dieses optische Signal durch den Verstärker verstärkt wird,
eine Vorrichtung, die dadurch gekennzeichnet ist, daß sie außerdem Mittel (16; T1; 74, 76) zur Detektion der zwischen den Anschlußklemmen des Verstärkers auftretenden elektrischen Spannung umfaßt, um in Form eines elektrischen Signals die durch das verstärkte optische Signal transportierten Informationen zu erhalten, wenn der Winkel zwischen der Polarisationsrichtung dieses optischen Signals und der Richtung der aktiven Schicht klein ist, wobei dieser Effekt optimal ist, wenn dieser Winkel Null ist und aufhört, wenn der Winkel gleich 90° ist.

4. Vorrichtung gemäß Anspruch 3, dadurch gekennzeichnet, daß der besagte Verstärker mit Halbleiterlaser vom Typ eines verteilten Resonators (2) einzeln und dazu bestimmt ist, um eine Vielzahl von intensitätsmodulierten und linear polarisierten optischen Signalen zu empfangen, deren entsprechende Wellenlängen voneinander verschieden sind, und deren Polarisationsrichtungen ineinander übergehen, um die Resonanzwellenlänge des Verstärkers mit der Wellenlänge eines der Signale zusammenfallen zu lassen.

5. Vorrichtung gemäß Anspruch 4, dadurch gekennzeichnet, daß die entsprechenden Polarisationsrichtungen der optischen Signale parallel zur Richtung der aktiven Schicht (14) des Verstärkers (2) sind.

6. Vorrichtung gemäß Anspruch 3, dadurch gekennzeichnet, daß sie N Verstärker mit Halbleiterlasern vom Typ der verteilten Resonatoren (D1, ... DN) umfaßt, die dazu bestimmt sind, um jeweils N intensitätsmodulierte und linear polarisierte optische Signale zu empfangen, deren entsprechende Wellenlängen voneinander verschieden sind, wobei N eine ganze Zahl und mindestens gleich 2 ist, um die Resonanzwellenlängen der N Verstärker entsprechend mit den N Wellenlängen der optischen Signale zusammenfallen zu lassen.

7. Vorrichtung gemäß Anspruch 6, dadurch gekennzeichnet, daß die entsprechenden aktiven Schichten (C1) der N Verstärker parallel sind und daß die entsprechenden Polarisationsrichtungen der N optischen Signale zueinander parallel sind, wobei die Richtungen der entsprechenden aktiven Schichten der N Verstärker zu diesen Polarisationsrichtungen parallel sind.

8. Vorrichtung gemäß Anspruch 3, dadurch gekennzeichent, daß sie zwei Verstärker mit Halbleiterlaser vom Typ der verteilten Resonatoren (66, 68) umfaßt, deren aktive Schichten (75, 77) senkrecht stehen und die dazu bestimmt sind, um jeder zwei optische Signale derselben Wellenlänge zu empfangen, welche intensitätsmoduliert und linear polarisiert sind, wobei die entsprechenden Polarisationsrichtungen dieser Signale senkrecht stehen und die eine der beiden parallel zur aktiven Schicht des einen der Verstärker ist, um die entsprechenden beiden optischen Signale durch die beiden Verstärker zu detektieren, wenn die Resonanzwellenlänge jedes dieser letzteren mit der besagten selben Wellenlänge zusammenfällt.

9. Vorrichtung gemäß Anspruch 8, dadurch gekennzeichnet, daß die beiden optischen Signale unabhängig sind.

10. Vorrichtung gemäß Anspruch 8, dadurch gekennzeichnet, daß die beiden optischen Signale quantisiert und zueinander komplementär sind und daß die Vorrichtung außerdem Subtrahierer (80) umfaßt, die dazu vorgesehen sind, um am Ausgang ein elektrisches Signal zu liefern, gleich der Differenz zwischen den entsprechenden, durch die Verstärker gelieferten, elektrischen Signale.

11. Vorrichtung gemäß Anspruch 3, dadurch gekennzeichnet, daß sie außerdem:
- zwei Verstärker mit Halbleiterlaser vom Typ der verteilten Resonatoren umfaßt, deren aktive Schichten (75, 77) senkrecht stehen und die dazu bestimmt sind, um jeder dasselbe optische Signal zu empfangen, wobei dieses optische Signal eine gegebene Wellenlänge hat und intensitäts-moduliert und linear polarisiert ist, und die Polarisationsrichtung dieses Signals parallel zur Richtung der aktiven Schicht eines der Verstärker ist, und
- Addierer (82) umfaßt, die dazu vorgesehen sind, um die entsprechend von den beiden Verstärkern gelieferten elektrischen Signale zu addieren, wenn die Resonanzwellenlänge von jedem dieser letzteren mit der gegebenen Wellenlänge zusammenfällt, um in Form eines elektrischen Signals am Ausgang der Addierer die, durch das besagte selbe optische Signal transportierten, Informationen zu erhalten.
